(19) Europäisches Patentamt / European Patent Office / Office européen des brevets

(11) **EP 4 478 569 B1**

(12) **EUROPEAN PATENT SPECIFICATION**

(45) Date of publication and mention
of the grant of the patent:
**11.03.2026 Bulletin 2026/11**

(21) Application number: **24164433.5**

(22) Date of filing: **19.03.2024**

(51) International Patent Classification (IPC):
*H02J 3/00* *(2026.01)*      *H02J 3/38* *(2026.01)*
*H02J 3/50* *(2026.01)*

(52) Cooperative Patent Classification (CPC):
**H02J 3/388; H02J 3/0012; H02J 3/381; H02J 3/50**

(54) **APPARATUS AND ISLANDING DETERMINATION METHOD FOR GRID DISTURBANCE**

VORRICHTUNG UND INSELBILDUNGSBESTIMMUNGSVERFAHREN FÜR EIN GESTÖRTES NETZ

APPAREIL ET PROCÉDÉ DE DÉTERMINATION D'ÎLOTAGE POUR UN RÉSEAU DÉRANGÉ

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **13.06.2023 KR 20230075487**

(43) Date of publication of application:
**18.12.2024 Bulletin 2024/51**

(73) Proprietor: **Hyundai Mobis Co., Ltd.**
**Gangnam-gu**
**Seoul 06141 (KR)**

(72) Inventors:
• **HONG, Seung Min**
**Suwon-si, Gyeonggi-do 16464 (KR)**
• **KIM, Hyeong Su**
**Hwaseong-si, Gyeonggi-do 18436 (KR)**

(74) Representative: **Frenkel, Matthias Alexander**
**Wuesthoff & Wuesthoff**
**Patentanwälte und Rechtsanwalt PartG mbB**
**Schweigerstraße 2**
**81541 München (DE)**

(56) References cited:
**US-A1- 2018 348 308**     **US-A1- 2020 161 868**

**Description**

BACKGROUND

1. Field

The disclosure relates to a method for determining islanding of a system in which a grid and distributed power supply power to a load.

2. Description of Related Art

When a distributed power operates in conjunction with a power system, a failure occurs in the power system. When the power system is separated and the distributed power supplies power to a load independently, it is called islanding. In order to quickly identify power system failures, it is necessary to quickly detect whether distributed power is operated in islanding mode and stop the islanding.

In general, a passive or active method is used to detect the islanding of distributed power.

The passive method measures voltage, current, and frequency in a system where distributed power are connected and determines whether or not distributed power is operated in islanding mode based on whether or not the power system is separated. Although the passive method is simple to implement and has excellent speed, there is a non-detection zone (NDZ) in which islanding cannot be determined when a change in values measured when disconnecting the system is small, and it is susceptible to sudden load changes in normal operation. Also, there is a disadvantage in that detection performance is poor when multiple distributed powers are applied.

In the active method, minute disturbance elements (e.g., reactive power) are injected into the connecting lines of the power system and changes in voltage/current or frequency due to this disturbance signal are detected, and whether distributed power is operated in islanding mode is determined based on whether or not the power system is separated. This conventional active method has the problem of lacking an equation and detailed determination logic for calculating an injection amount of reactive power, and in a system where disturbance and distortion exist, there is problems such as false detection of islanding.

US 2020/161868 A1 discloses a power converting apparatus capable of preventing islanding operation when connected to a commercial power grid, thereby enabled to output stable alternating current (AC) power to a grid. The apparatus includes an islanding operation detector configured to calculate a first frequency variation of the AC power output from the inverter, selectively inject reactive power of the solar cell module based on the first frequency variation, and perform control to turn off the inverter based on whether a second frequency variation of a grid voltage of the grid after the injection of the reactive power of the solar cell module is greater than or equal to a preset value.

US 2018/348308 A1 discloses an electric power system capable of detecting an islanding condition in which the utility grid has become unavailable, e.g., due to disconnection or malfunction. The system includes an island detection circuitry configured to inject a perturbation current at the power output based upon a perturbation current signal, receive a voltage signal from the power output, crosscorrelate the perturbation current signal with the voltage signal to provide a cross-correlation signal, and determine an island condition based upon the cross-correlation signal.

SUMMARY

The invention is directed to a method for determining islanding of a system in which a grid and distributed power supply power to a load, according to claim 1. Preferred embodiments are defined in the dependent claims.

The disclosure has been created to solve the problems described above, and an object of the disclosure is to provide a method for determining islanding in a disturbance and distortion system comprising a specific equation and determination process for injecting reactive power as an islanding determination method, and providing an islanding determination method in a disturbance and distortion system that does not cause false detection even in sections where disturbances and distortions, i.e., harmonics, exist in the system.

According to the present invention, a method for determining islanding of a system in which a grid and distributed power supply power to a load is set forth in claim 1. Preferred embodiments are provided in the dependent claims. The method for determining islanding of a system in which a grid and distributed power supply power to a load, includes the steps of: a) calculating an amount of reactive power injection based on an active power command and reactive power command received from a upper controller outside of the distributed power, and setting a failure confirmation count to 0; b) injecting reactive power during a preset cycle among predetermined cycles of an AC voltage that is an output AC voltage of the distributed power according to the failure confirmation count; c) measuring a frequency and angular frequency of the AC voltage, which is performed simultaneously with the step b); d), after the step b) is completed, increasing the failure confirmation count if a determination criteria based on the frequency and angular frequency measured in the step c) is satisfied; and e), after the step d) is performed, determining an islanding failure when the failure confirmation count reaches a preset value, wherein the step b), the step c), the step d), and the step e) are repeatedly performed until the islanding failure is confirmed in the step e).

The step a) may include the steps of: a-1) measuring an instantaneous value of the AC voltage at a connection point between the grid and the distributed power using a voltage measurement circuit included in the distributed power, and calculating an effective value and frequency of the AC voltage using the instantaneous value; a-2) calculating a resistance value of the load using active power output from the distributed power; a-3) calculating an inductor value and capacitor value of the load using a preset power quality coefficient; and a-4) determining the amount of the reactive power injection using the effective value of the AC voltage, the inductor value, the capacitor value, and a magnitude of injection frequency.

In the step a-1), the effective value and frequency of the AC voltage may be repeatedly calculated at regular cycles using the instantaneous value.

In the step a-4), the amount of the reactive power injection is calculated using an equation below:

$$Q_{inj} = V_{rms}^2 * (\frac{1}{2\pi f_{inj} L_{load}} - 2\pi f_{inj} C_{load})$$

where, $Q_{inj}$ is the amount of the reactive power injection, $V_{rms}$ is the effective value of the AC voltage, $f_{inj}$ is the magnitude of the frequency of the reactive power, $L_{load}$ is the inductor value of the load, and $C_{load}$ is the capacitor value of the load.

The step a-4) may determine the magnitude of the frequency of the reactive power using an equation below:

$$f_{inj} = f_{grid} + \triangle f_{inj}$$

$$-Q_{acc} * Q_{rated} < Q_{inj} < +Q_{acc} * Q_{rated}$$

$$f_{grid} = 2\pi \frac{1}{\sqrt{L_{load} C_{load}}}$$

where, $f_{grid}$ is a frequency of the grid, $\Delta f_{inj}$ is an increment of the frequency of the reactive power, $Q_{acc}$ is a preset reactive power accuracy, and $O_{rated}$ is a rated reactive power of the distributed power.

In the step b), the reactive power may be injected during m cycles among n cycles of the AC voltage, and as the failure confirmation count increases, the m and the n may be changed so that a value obtained by dividing the m by the n increases.

In the step b), when the failure confirmation count is 0, the reactive power may be injected for 3 cycles out of 8 cycles of the AC voltage, when the failure confirmation count is 1, the reactive power may be injected for 3 cycles out of 5 cycles of the AC voltage, and when the failure confirmation count is 2, the reactive power may be injected during 4 cycles out of 5 cycles of the AC voltage.

The step e) may include confirming the islanding failure when the failure confirmation count is 3.

In the step b), the reactive power may be alternately injected in plus and minus directions.

In the step c), the angular frequency is measured by measuring an output of PLL included in the distributed power.

In the step b), the reactive power is injected during a first section in which the reactive power linearly increases, a second section in which the reactive power is maintained, and a third section in which the reactive power linearly decreases, and in the step c), when the failure confirmation count is 0 or 1, the frequency is measured at three time points in the second section, and the angular frequency is measured at first and last time points among the three time points.

In the step d), if all of determination criteria below are satisfied, the failure confirmation count is increased using an equation below:

$$|\omega_1 - \omega_3| \geq |2\pi\Delta f_{inj}|$$

$$(f_1 < f_2 < f_3) \| (f_1 > f_2 > f_3)$$

where, $\omega_1$ is the angular frequency measured at the first time point of the three time points, $\omega_3$ is the angular frequency measured at the last time point among the three time points, $f_1, f_2, f_3$ are the frequencies measured sequentially at the three time points, and $\Delta f_{inj}$ is an increment of the injection frequency.

In the step c), when the failure confirmation count is 2, the frequency may be measured at four time points in the second section, and the angular frequency may be measured at first and last time points of the four time points, using an equation below:

$$\left| \omega_1 - \omega_4 \right| \geq \left| 2\pi \Delta f_{inj} \right|$$

$$(f_1 < f_2 < f_3 < f_4) \| (f_1 > f_2 > f_3 > f_4)$$

$$\left| f_1 - f_4 \right| \geq \Delta f_{inj}$$

where $\omega_1$ is the angular frequency measured at the first time point of the four time points, $\omega_4$ is the angular frequency measured at the last time point among the four time points, $f_1, f_2, f_3, f_4$ are the frequencies measured sequentially at the four time points, and $\Delta f_{inj}$ is an increment of the injection frequency.

BRIEF DESCRIPTION OF THE DRAWINGS

FIG. 1 is a diagram schematically illustrating a power system to which an islanding determination method is applied in a disturbance and distortion system according to an embodiment of the disclosure.

FIG. 2 is a block diagram of active power and reactive power control in an islanding determination method in a disturbance and distortion system according to an embodiment of the disclosure.

FIG. 3 is a flowchart of an islanding determination method in a disturbance and distortion system according to an embodiment of the disclosure.

FIG. 4 is a detailed flowchart of step a) in an islanding determination method in a disturbance and distortion system according to an embodiment of the disclosure.

FIG. 5 is a block diagram of SRF-PLL which is a PLL used in an islanding determination method in a disturbance and distortion system according to an embodiment of the disclosure.

FIG. 6 is a graph of reactive power, frequency of AC voltage, angular frequency as output value of PLL, and failure confirmation count while applying an islanding determination method in a disturbance and distortion system according to an embodiment of the disclosure.

DETAILED DESCRIPTION

The aforementioned objects, features, and advantages of the disclosure will be clearer through the following embodiment associated with the accompanying drawings. The following specific structure or functional explanations are illustrated to describe embodiments in accordance with the concept of the disclosure. The embodiments in accordance with the concept of the disclosure may be embodied in various forms but are not interpreted to be limited to the embodiments described in this specification or application. Various modifications and changes may be applied to the embodiments within the scope of the present invention defined by the appended claims. Terms such as first or second may be used to describe various components but the components are not limited by the above terminologies. The above terminologies are used to distinguish one component from the other component, for example, a first component may be referred to as a second component without departing from a scope in accordance with the concept of the disclosure and similarly, a second component may be referred to as a first component. It should be understood that, when it is described that an element is coupled or connected to another element, the element may be directly coupled or directly connected to the other element or coupled or connected to the other element through a third element. On the contrary, it should be understood that when an element is referred to as being directly connected to or directly coupled to another element, another element does not intervene therebetween. Other expressions to describe the relationship between elements, that is, expressions such as "between", "immediately between", "adjacent to", or "directly adjacent to" need to be also similarly interpreted. Terms used in the specification are used only to describe specific embodiments, and are not intended to limit the disclosure. A singular form may include a plural form if there is no clearly opposite meaning in the context. In the specification, it should be understood that the term "include" or "have" indicates that a feature, a number, a step, an operation, a component, a part or the combination thereof described in the specification is present, but does not exclude a possibility of presence or addition of one or more other features, numbers, steps, operations, components, parts or combinations thereof, in advance. If it is not contrarily defined, all terms used herein including technological or scientific terms have the same meaning as those generally understood by a person with ordinary skill in the art. Terms which are defined in a generally used dictionary should be interpreted to have the same meaning as the meaning in the context of the related art but are not interpreted as an ideally or excessively formal meaning if it is not clearly defined in this specification. Hereinafter, embodiments of the disclosure will be described in detail with reference to the accompanying drawings. The same reference numerals indicated in respective drawings will be employed as those for representing the same members.

The disclosure relates to a method for detecting an islanding of a distributed power in a power system in which a grid and distributed power supply power to loads. Here, the distributed power may be various types of renewable energy generation devices or on board charger (OBC) of electric vehicles operating in vehicle to grid (V2G).

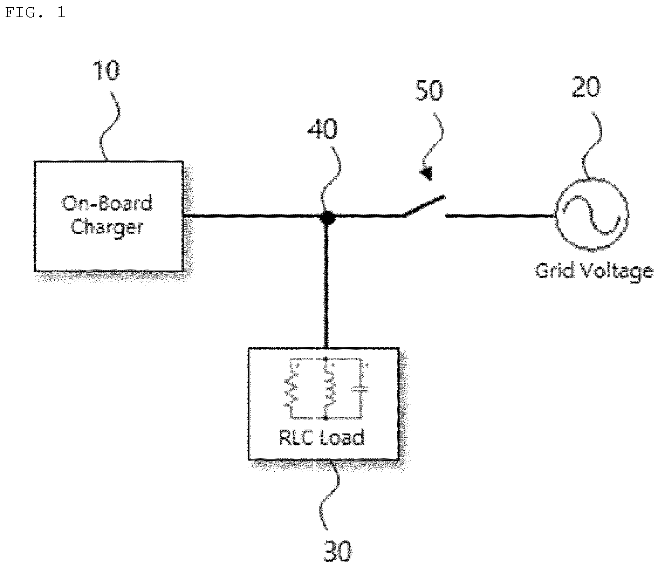

FIG. 1 is a diagram schematically illustrating a power system to which an islanding determination method is applied in a disturbance and distortion system according to an embodiment of the disclosure.

As illustrated in FIG. 1, an OBC 10 and a grid 20 may supply power to a load 30, and the load 30 may be connected to a point common coupling (PCC) 40 located between the OBC 10 and the grid 20, and a recloser 50 may be located between the PCC 40 and the grid 20.

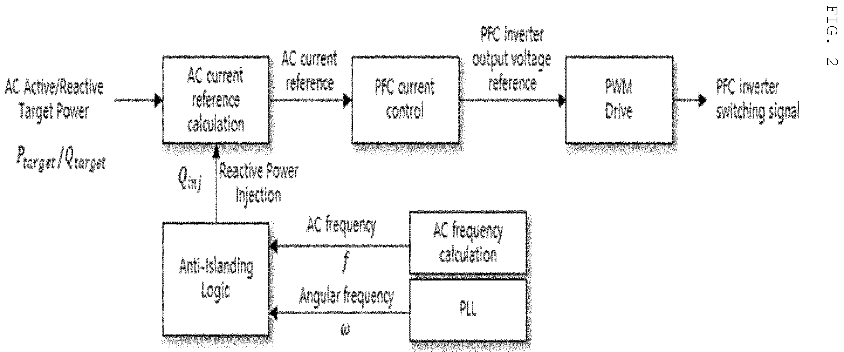

FIG. 2 is a block diagram of active power and reactive power control in an islanding determination method in a disturbance and distortion system according to an embodiment of the disclosure.

As illustrated in FIG. 2, an AC current command calculation logic uses the active power and reactive power commands received from an upper controller outside a charger and the reactive power, which is an output value of an islanding prevention logic that performs the algorithm of the disclosure, to calculate an AC current command. A PFC inverter current controller calculates a PFC inverter voltage command to control the current according to the calculated current command and sends a switching signal by a PWM output logic.

The block diagram illustrated in FIG. 2 may be controlled by a controller that controls the OBC 10. Here, the controller may be implemented with various devices included in the OBC 10, for example, an electronic device or an apparatus including an electronic device, which receives measured values or signals from a device such as the PLL illustrated in FIG. 2 and control the OBC 10 based on the received signals.

Referring to FIG. 2, when the OBC 10 operates in V2G mode, after receiving the active power command $P_{target}$ and reactive power command $Q_{target}$ received from the upper controller of an electric vehicle, reactive power is injected according to the received $P_{target}$ and $Q_{target}$. It is determined whether to operate islanding based on the frequency change rate, angular frequency change amount, and frequency change amount according to the injected reactive power. The method includes steps a) to e) sequentially performed by the above-described controller.

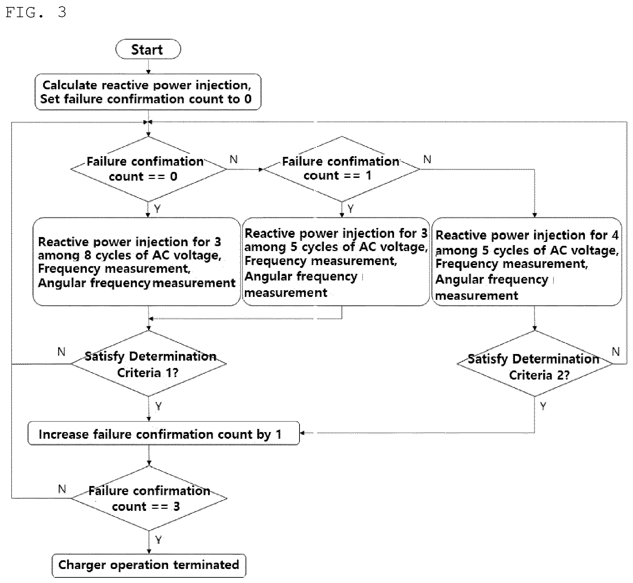

FIG. 3 is a flowchart of an islanding determination method in a disturbance and distortion system according to an embodiment of the disclosure.

Referring to FIG. 3, step a) calculates an amount of reactive power injection $Q_{inj}$ based on the distributed power, that is, $P_{target}$ and $Q_{target}$ received from the upper controller of the OBC 10, and sets a failure confirmation count to 0. Step a) described above includes steps a-1) to a-4) that are performed sequentially.

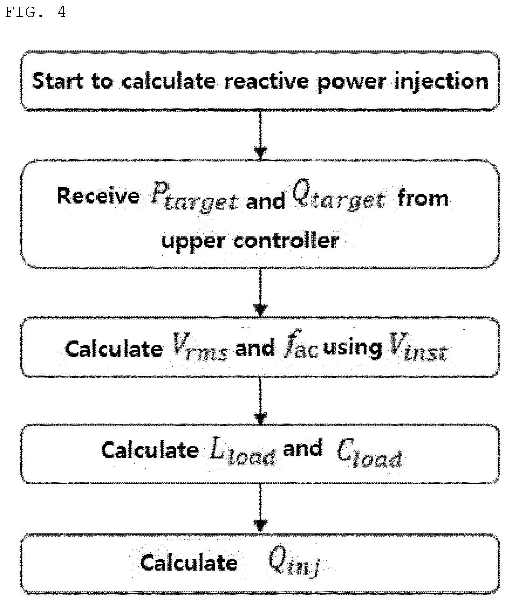

FIG. 4 is a detailed flowchart of step a) in an islanding determination method in a disturbance and distortion system according to an embodiment of the disclosure.

Referring to FIG. 4, in step a-1), the controller measures $V_{inst}$, which is an instantaneous value in the PCC 40, using a voltage measurement circuit included in the OBC 10 or electric vehicle side, and uses $V_{inst}$ to calculate the effective value $V_{rms}$ and frequency $f_{grid}$ of an AC voltage, which is the output voltage of the OBC 10. A known method is used to calculate $V_{rms}$ and $f_{grid}$ using instantaneous values. Briefly, the instantaneous value $V_{inst}$ is converted from a time domain to a periodic function in a frequency domain using frequency analysis or Fourier transform. Afterwards, the controller identifies the frequency component of the voltage in the frequency domain. Generally, the controller selects the largest frequency component and calculates the frequency based on the selected frequency component. The controller uses voltage data corresponding to the selected frequency component to calculate the effective value $V_{rms}$. More specifically, the controller may square the voltage data for the selected frequency component to obtain an average, and then obtain the effective value $V_{rms}$ through the square root.

Step a-1) described above is repeatedly performed for each cycle of the AC voltage, which is the output voltage of the OBC 10, so that the effective value and frequency may be repeatedly calculated.

Referring to FIG. 4, in step a-2), the controller calculates the resistance value of the load 30 using the active power output from the OBC 10. Referring to FIG. 1, when the recloser 50 is opened, the OBC 10 is independently connected to the RLC load 30 to supply power. In this case, using the active power supplied to the load 30, $R_{load}$ which is the resistance value of the load 30, may be obtained, and the equation for calculating $R_{load}$ is as follows.

[Equation 1]

$$R_{load} = \frac{V_{rms}^2}{P_{target}}$$

Referring to FIG. 4, in step a-3), the controller calculates the inductor values of the load 30, $L_{load}$ and $C_{load}$, using $Q_f$, which is a preset power quality coefficient.

To calculate $L_{load}$ and $C_{load}$ in step a-3), the controller may use Equations 2 and 3 below.

[Equation 2]

$$f_{grid} = 2\pi \frac{1}{\sqrt{L_{load}C_{load}}}$$

[Equation 3]

$$Q_f = R_{Load}\sqrt{\frac{C_{Load}}{L_{Load}}}$$

$$L_{Load} = \frac{R_{load}}{2\pi f_{grid}Q_f}$$

$$C_{Load} = \frac{Q_f}{2\pi f_{grid}R_{load}}$$

In Equation 2 and Equation 3 above, $f_{grid}$, $Q_f$ and $R_{Load}$ are already known values, and in step a-3), the controller calculates $L_{load}$ and $C_{load}$ using the above equation.

In step a-4), the controller calculates an amount of reactive power injection $Q_{inj}$ using the effective value of the AC voltage $V_{rms}$, an inductor value $L_{load}$, a capacitor value $C_{load}$, and the magnitude of injection frequency $f_{inj}$. The controller may calculate $Q_{inj}$ using the equation below.

[Equation 4]

$$Q_{inj} = V_{rms}^2 * (\frac{1}{2\pi f_{inj}L_{load}} - 2\pi f_{inj}C_{load})$$

In the above equation, the magnitude of injection frequency, $f_{inj}$ may be calculated using the equation below.

[Equation 5]

$$f_{inj} = f_{grid} + \Delta f_{inj}$$

As can be seen from Equation 5 above, the injection frequency $f_{inj}$ may be obtained by adding the injection frequency increment $\Delta f_{inj}$ to the frequency $f_{grid}$ of the system 20. Here, the injection frequency increment $\Delta f_{inj}$ can be determined through the equation below.

## [Equation 6]

$$-Q_{acc} * Q_{rated} < Q_{inj} < +Q_{acc} * Q_{rated}$$

In Equation 6 above, $Q_{acc}$, is the preset reactive power accuracy, and $Q_{rated}$ is the rated reactive power of the distributed power. After substituting Equation 5 into Equation 4, and then substituting the defined $Q_{inj}$ in Equation 4 into Equation 6, the defined $Q_{inj}$ including $\Delta f_{inj}$ is determined to be within a predetermined range. When Equation 5 is substituted into Equation 4, there are only variable $\Delta f_{inj}$ on the right side, so in Equation 6, $\Delta f_{inj}$ is determined to be within a specific range.

In step b), according to the failure confirmation count, reactive power is injected by the size of the reactive power $Q_{inj}$ calculated in step a) during a preset cycle of preset cycles of the AC voltage. Since the failure confirmation count is set to 0 in step a) described above, in this embodiment, the controller injects reactive power for 3 of the 8 cycles of the AC voltage. Additionally, in step b), reactive power is injected so that plus and minus directions appear alternately.

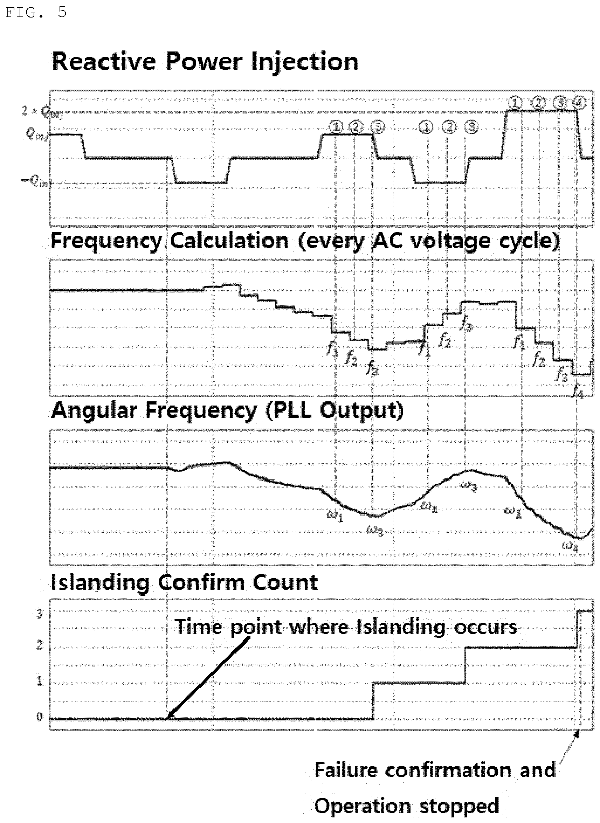

Step c) is performed simultaneously with step b), and in step c), the controller measures the frequency and angular frequency of the AC voltage. Here, the angular frequency is the output value of the PLL included in the OBC 10 according to this embodiment. FIG. 5 is a block diagram of SRF-PLL which is a PLL used in an islanding determination method in a disturbance and distortion system according to an embodiment of the disclosure.

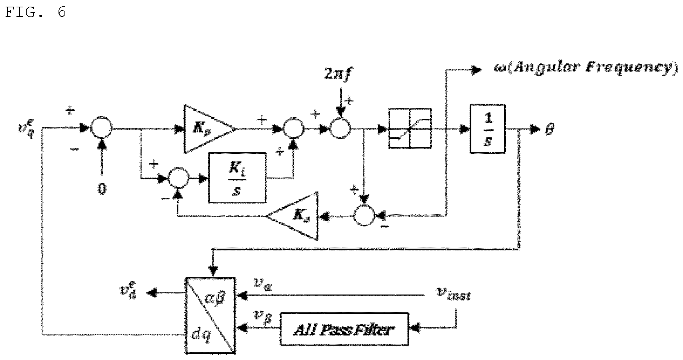

FIG. 6 is a graph of reactive power, frequency of AC voltage, angular frequency as output value of PLL, and failure confirmation count while applying an islanding determination method in a disturbance and distortion system according to an embodiment of the disclosure.

Referring to FIG. 6, when the controller injects reactive power in step b), the reactive power is injected in forms of a first section in which the reactive power increases linearly to a target value, a second section in which the reactive power value is maintained, and a third section in which the reactive power decreases linearly. In other words, reactive power is injected in a kind of trapezoidal shape.

In step c), if the fault confirmation count is 0 or 1, the controller measures the frequencies at three points in the second section where reactive power is maintained, and these frequencies are called $f_1$, $f_2$, $f_3$ Based on the time point, the frequency with the smaller subscript is the frequency measured first. Among the above frequencies, $f_3$ may be a frequency measured at the end of the second section and the start of the third section. Also, in step c), if the failure confirmation count is 0 or 1, each frequency is measured at the first and last time points among the three time points when the frequency has been measured. $\omega_1$ and $\omega_3$ refer to the angular frequencies measured at the first and last time points in order, respectively. The above $\omega_3$ may be an angular frequency measured at the end of the second section and the start of the third section.

In step c), if the failure confirmation count is 2, the controller measures the frequency at each of the four points in the second section where reactive power is maintained, and these frequencies are referred to as $f_1$, $f_2$, $f_3$, $f_4$. Based on the time point, the frequency with the smaller subscript is the frequency measured first. Among the above frequencies, $f_4$ may be a frequency measured at the end of the second section and the start of the third section. Also, in step c), if the failure confirmation count is 2, each frequency is measured at the first and last time points among the four time points when the frequency has been measured. $\omega_1$ and $\omega_4$ refer to the angular frequencies measured at the first and last time points in order, respectively. The above $\omega_4$ may be an angular frequency measured at the end of the second section and the start of the third section.

In step d), after step b) is completed, the controller increases the failure confirmation count according to a predetermined criterion based on the frequency and angular frequency measured in step c) and the failure confirmation count. More specifically, when the failure confirmation count is 0 or 1, in step d), the controller increases the failure confirmation count by 1 if all of the following determination criteria are satisfied, and maintains the failure confirmation count if all of the following determination criteria are not satisfied.

## [Determination Criteria 1]

$$\left| \omega_1 - \omega_3 \right| \geq \left| 2\pi \Delta f_{inj} \right|$$

$$(f_1 < f_2 < f_3) \| (f_1 > f_2 > f_3)$$

The condition in the second line of Determination Criteria 1 above means the 'or' condition.

In step d), when the failure confirmation count is 2, the controller increases the failure confirmation count by 1 if all of the following determination criteria are satisfied, and maintains the failure confirmation count if all of the following judgment criteria are not satisfied.

[Determination Criteria 2]

$$\left|\omega_1 - \omega_4\right| \geq \left|2\pi\Delta f_{inj}\right|$$

$$(f_1 < f_2 < f_3 < f_4) \| (f_1 > f_2 > f_3 > f_4)$$

$$\left|f_1 - f_4\right| \geq \Delta f_{inj}$$

In step e), the controller determines an islanding failure when the failure confirmation count reaches a preset value after step d) is performed. In this embodiment, the preset value may be 3.

Steps b) to e) may be repeatedly performed until the controller determines the islanding failure in step e).

In the above step b), it is described that the controller injects reactive power for 3 out of 8 cycles of the AC voltage when the failure confirmation count is 0. In addition, in step b), the controller injects reactive power for 3 out of 5 cycles of the AC voltage when the failure confirmation count is 1, and injects reactive power for 4 out of 5 cycles of the AC voltage when the failure confirmation count is 2. However, injecting reactive power for several cycles among predetermined cycles of the AC voltage according to the failure confirmation count is only one embodiment, and the values of preset cycle of the AC voltage and cycle of injecting the reactive power may vary. However, in step b) of the disclosure, when reactive power is injected during m cycles out of n cycles of AC voltage, the value obtained by dividing n by m, that is, the proportion of cycles injecting reactive power among the total cycles of AC voltage may increase as the failure confirmation count increases (m is a natural number less than or equal to n). One or more processors or controllers may be configured to control or actuate the steps above.

According to the disclosure as described above, there is no false detection even in sections where harmonics exist in the system, and the amount of reactive power injection can be calculated in real time through an equation using the active power and reactive power control commands from the upper controller. Therefore, even if the active power command and reactive power command change, islanding can be determined within a certain time.

According to the islanding determination method in a disturbance and distortion system according to the disclosure as described above, no false detection is made even in sections where harmonics exist in the system, and the amount of reactive power injection is calculated using the active power and reactive power control commands of the upper controller. Thus, it has the effect of being able to determine the islanding within a certain time even if the active power command and reactive power command change.

Although preferred embodiments of the disclosure have been described above, the embodiments disclosed in the disclosure are not intended to limit the technical scope of the present invention but are only for explanation. Accordingly, the technical scope of the present invention includes not only each disclosed embodiment, but also a combination of the disclosed embodiments, and furthermore, the scope of the present invention is not limited by these embodiments. Also, it will be apparent to those having ordinary skill in the art that a number of changes, modifications, or alterations to the invention as described herein may be made within the scope of the present invention defined by the appended claims.

**Claims**

1. A method for determining islanding of a system in which a grid (20) and distributed power (10) supply power to a load (30), the method comprising the steps of:

   a) calculating an amount of reactive power injection based on an active power command and reactive power command received from a controller outside the distributed power (10), and setting a failure confirmation count to 0;
   b) injecting reactive power during a preset cycle among predetermined cycles of an AC voltage that is an output AC voltage of the distributed power (10) according to the failure confirmation count;
   c) measuring a frequency and angular frequency of the AC voltage, which is performed simultaneously with the step b);
   d), after the step b) is completed, increasing the failure confirmation count if a determination criteria based on the frequency and angular frequency measured in the step c) is satisfied; and
   e), after the step d) is performed, determining an islanding failure when the failure confirmation count reaches a preset value,

wherein the step b), the step c), the step d), and the step e) are repeatedly performed until the islanding failure is confirmed in the step e),

wherein in the step c), the angular frequency is measured by measuring an output of PLL included in the distributed power (10),

wherein in the step b), the reactive power is injected during a first section in which the reactive power linearly increases, a second section in which the reactive power is maintained, and a third section in which the reactive power linearly decreases, and

wherein in the step c), when the failure confirmation count is 0 or 1, the frequency is measured at three time points in the second section, and the angular frequency is measured at first and last time points among the three time points, and

wherein in the step d), if all of determination criteria below are satisfied, the failure confirmation count is increased:

$$|\omega_1 - \omega_3| \geq |2\pi\Delta f_{inj}|\ ;$$

and

$$(f_1 < f_2 < f_3) \quad \text{or} \quad (f_1 > f_2 > f_3)$$

where $\omega_1$ is the angular frequency measured at the first time point of the three time points, $\omega_3$ is the angular frequency measured at the last time point among the three time points, $f_1$, $f_2$, $f_3$ are the frequencies measured sequentially at the three time points, and $\Delta f_{inj}$ is an increment of the frequency of the reactive power.

2. The method of claim 1, wherein the step a) comprises the steps of:

a-1) measuring an instantaneous value of the AC voltage at a connection point between the grid (20) and the distributed power (10) using a voltage measurement circuit included in the distributed power (10), and calculating an effective value and frequency of the AC voltage using the instantaneous value;

a-2) calculating a resistance value of the load, $R_{load}$, (30) using active power output from the distributed power (10);

a-3) calculating an inductor value, $L_{Load}$, and capacitor value, $C_{Load}$, of the load (30) using a preset power quality coefficient, $Q_f$, according to the following equations:

$$L_{Load} = \frac{R_{load}}{2\pi f_{grid} Q_f}$$

$$C_{Load} = \frac{Q_f}{2\pi f_{grid} R_{load}}$$

wherein $f_{grid}$ is the frequency of the AC voltage calculated at step a-1); and

a-4) calculating the amount of the reactive power injection using the effective value of the AC voltage, the inductor value, the capacitor value, and a magnitude of the frequency of the reactive power.

3. The method of claim 2, wherein in the step a-1), the effective value and frequency of the AC voltage are repeatedly calculated at regular cycles using the instantaneous value.

4. The method of claim 2 or 3, wherein in the step a-4), the amount of the reactive power injection is calculated using an equation below:

$$Q_{inj} = V_{rms}^2 * \left(\frac{1}{2\pi f_{inj} L_{load}} - 2\pi f_{inj} C_{load}\right)$$

where, $Q_{inj}$ is the amount of the reactive power injection, $V_{rms}$ is the effective value of the AC voltage, $f_{inj}$ is the magnitude of the frequency of the reactive power, $L_{load}$ is the inductor value of the load (30), and $C_{load}$ is the capacitor value of the load (30).

5. The method of claim 4, wherein the step a-4) determines the magnitude of the frequency of the reactive power according to below:

$$f_{inj} = f_{grid} + \triangle f_{inj}$$

$$-Q_{acc} * Q_{rated} < Q_{inj} < +Q_{acc} * Q_{rated}$$

$$f_{grid} = 2\pi \cdot 1/\sqrt{(L_{load} \cdot C_{load})}$$

$$Q_{inj} = V_{rms}^2 * \left(\frac{1}{2\pi f_{inj} L_{load}} - 2\pi f_{inj} C_{load}\right)$$

where $f_{grid}$ is a frequency of the grid (20), $\Delta f_{inj}$ is an increment of the frequency of the reactive power, $Q_{acc}$ is a preset reactive power accuracy, and $Q_{rated}$ is a rated reactive power of the distributed power (10).

6. The method of any one of claims 1 to 5, wherein in the step b), the reactive power is injected during m cycles among n cycles of the AC voltage, and as the failure confirmation count increases, the m and the n are changed so that a value obtained by dividing the m by the n increases.

7. The method of claim 6, wherein in the step b),

when the failure confirmation count is 0, the reactive power is injected for 3 cycles out of 8 cycles of the AC voltage,
when the failure confirmation count is 1, the reactive power is injected for 3 cycles out of 5 cycles of the AC voltage, and
when the failure confirmation count is 2, the reactive power is injected during 4 cycles out of 5 cycles of the AC voltage.

8. The method of any one of claims 1 to 7, wherein the step e) comprises confirming the islanding failure when the failure confirmation count is 3.

9. The method of any one of claims 1 to 8, wherein in the step b), the reactive power is alternately injected in plus and minus directions.

10. The method of claim 1,

wherein in the step c), when the failure confirmation count is 2, the frequency is measured at four time points in the second section, and the angular frequency is measured at first and last time points of the four time points, using an equation below:

$$|\omega_1 - \omega_4| \geq |2\pi \Delta f_{inj}| \quad ;$$

$$(f_1 < f_2 < f_3 < f_4) \quad \text{or} \quad (f_1 > f_2 > f_3 > f_4) \quad ;$$

and

$$|f_1 - f_4| \geq \Delta f_{inj}$$

where $\omega_1$ is the angular frequency measured at the first time point of the four time points, $\omega_4$ is the angular frequency measured at the last time point among the four time points, $f_1$, $f_2$, $f_3$, $f_4$ are the frequencies measured sequentially at the four time points, and $\Delta f_{inj}$ is an increment of the frequency of the reactive power.

**Patentansprüche**

1. Verfahren zur Bestimmung einer Inselbildung eines Systems, in dem ein Netz (20) und eine verteilte Stromversorgung (10) eine Last (30) mit Strom versorgen, wobei das Verfahren die folgenden Schritte umfasst:

   a) Berechnen einer Menge an Blindleistungsinjektion auf der Grundlage eines Wirkleistungsbefehls und eines Blindleistungsbefehls, die von einer Steuerung außerhalb der verteilten Stromversorgung (10) empfangen werden, und Setzen eines Fehlerbestätigungszählers auf 0;
   b) Injizieren von Blindleistung während eines voreingestellten Zyklus unter vorbestimmten Zyklen einer Wechselspannung, die eine Ausgangswechselspannung der verteilten Stromversorgung (10) ist, gemäß dem Fehlerbestätigungszähler;
   c) Messen einer Frequenz und einer Kreisfrequenz der Wechselspannung, was gleichzeitig mit dem Schritt b) durchgeführt wird;
   d) nach Abschluss des Schritts b), Erhöhen des Fehlerbestätigungszählers, wenn ein Bestimmungskriterium auf der Grundlage der in Schritt c) gemessenen Frequenz und Kreisfrequenz erfüllt ist; und
   e) nach Durchführung des Schritts d), Bestimmen eines Inselbildungsfehlers, wenn der Fehlerbestätigungszähler einen voreingestellten Wert erreicht,
   wobei der Schritt b), der Schritt c), der Schritt d) und der Schritt e) wiederholt durchgeführt werden, bis der Inselbildungsfehler im Schritt e) bestätigt wird,
   wobei im Schritt c) die Kreisfrequenz durch Messen eines Ausgangs einer in der verteilten Stromversorgung (10) enthaltenen PLL gemessen wird,
   wobei im Schritt b) die Blindleistung während eines ersten Abschnitts, in dem die Blindleistung linear zunimmt, eines zweiten Abschnitts, in dem die Blindleistung beibehalten wird, und eines dritten Abschnitts, in dem die Blindleistung linear abnimmt, injiziert wird, und
   wobei im Schritt c), wenn der Fehlerbestätigungszähler 0 oder 1 ist, die Frequenz zu drei Zeitpunkten im zweiten Abschnitt gemessen wird und die Kreisfrequenz zu ersten und letzten Zeitpunkten unter den drei Zeitpunkten gemessen wird, und
   wobei im Schritt d) der Fehlerbestätigungszähler erhöht wird, wenn alle nachstehenden Bestimmungskriterien erfüllt sind:

$$|\omega_1 - \omega_3| \geq |2\pi\,\Delta f_{inj}| \quad ;$$

   und

$$(f_1 < f_2 < f_3) \;\text{oder}\; (f_1 > f_2 > f_3)$$

   wobei $\omega_1$ die Kreisfrequenz ist, die zum ersten Zeitpunkt der drei Zeitpunkte gemessen wird, $\omega_3$ die Kreisfrequenz ist, die zum letzten Zeitpunkt unter den drei Zeitpunkten gemessen wird, $f_1$, $f_2$, $f_3$ die sequentiell zu den drei Zeitpunkten gemessenen Frequenzen sind, und $\Delta f_{inj}$ ein Inkrement der Frequenz der Blindleistung ist.

2. Verfahren nach Anspruch 1, wobei der Schritt a) die folgenden Schritte umfasst:

   a-1) Messen eines Momentanwerts der Wechselspannung an einem Verbindungspunkt zwischen dem Netz (20) und der verteilten Stromversorgung (10) unter Verwendung einer in der verteilten Stromversorgung (10) enthaltenen Spannungsmessschaltung und Berechnen eines Effektivwerts und einer Frequenz der Wechselspannung unter Verwendung des Momentanwerts;
   a-2) Berechnen eines Widerstandswerts, $R_{load}$, der Last (30) unter Verwendung der von der verteilten Stromversorgung (10) ausgegebenen Wirkleistung;
   a-3) Berechnen eines Induktivitätswerts, $L_{load}$, und eines Kapazitätswerts, $C_{load}$, der Last (30) unter Verwendung eines voreingestellten Stromqualitätskoeffizienten, $Q_{f,}$ gemäß den folgenden Gleichungen:

$$L_{load} = \frac{R_{load}}{2\pi\, f_{grid}\, Q_f}$$

$$C_{load} = \frac{Q_f}{2\pi\, f_{grid}\, R_{load}}$$

wobei $t_{grid}$ die in Schritt a-1) berechnete Frequenz der Wechselspannung ist; und
a-4) Berechnen der Menge der Blindleistungsinjektion unter Verwendung des Effektivwerts der Wechselspannung, des Induktivitätswerts, des Kapazitätswerts und einer Größe der Frequenz der Blindleistung.

3. Verfahren nach Anspruch 2, wobei im Schritt a-1) der Effektivwert und die Frequenz der Wechselspannung wiederholt in regelmäßigen Zyklen unter Verwendung des Momentanwerts berechnet werden.

4. Verfahren nach Anspruch 2 oder 3, wobei im Schritt a-4) die Menge der Blindleistungsinjektion unter Verwendung einer nachstehenden Gleichung berechnet wird:

$$Q_{inj} = V_{rms}^2 * \left( \frac{1}{2\pi\, f_{inj}\, L_{load}} - 2\pi\, f_{inj}\, C_{load} \right)$$

wobei $Q_{inj}$ die Menge der Blindleistungsinjektion ist, $V_{rms}$ der Effektivwert der Wechselspannung ist, $f_{inj}$ die Größe der Frequenz der Blindleistung ist, $L_{loag}$ der Induktivitätswert der Last (30) ist und $C_{load}$ der Kapazitätswert der Last (30) ist.

5. Verfahren nach Anspruch 4, wobei der Schritt a-4) die Größe der Frequenz der Blindleistung gemäß Folgendem bestimmt:

$$f_{inj} = f_{grid} + \Delta f_{inj}$$

$$-Q_{acc} * Q_{rated} < Q_{inj} < +Q_{acc} * Q_{rated}$$

$$f_{grid} = 2\pi \frac{1}{\sqrt{L_{load}\, C_{load}}}$$

$$Q_{inj} = V_{rms}^2 * \left( \frac{1}{2\pi\, f_{inj}\, L_{load}} - 2\pi\, f_{inj}\, C_{load} \right)$$

wobei $t_{grid}$ eine Frequenz des Netzes (20) ist, $\Delta f_{inj}$ ein Inkrement der Frequenz der Blindleistung ist, $Q_{acc}$ eine voreingestellte Blindleistungsgenauigkeit ist, und $Q_{rated}$ eine Nennblindleistung der verteilten Stromversorgung (10) ist.

6. Verfahren nach einem der Ansprüche 1 bis 5, wobei im Schritt b) die Blindleistung während m Zyklen von n Zyklen der Wechselspannung injiziert wird, und wenn der Fehlerbestätigungszähler zunimmt, das m und das n so geändert werden, dass ein durch Dividieren des m durch das n erhaltener Wert zunimmt.

7. Verfahren nach Anspruch 6, wobei im Schritt b),

wenn der Fehlerbestätigungszähler 0 ist, die Blindleistung für 3 Zyklen von 8 Zyklen der Wechselspannung injiziert wird,

wenn der Fehlerbestätigungszähler 1 ist, die Blindleistung für 3 Zyklen von 5 Zyklen der Wechselspannung injiziert wird, und
wenn der Fehlerbestätigungszähler 2 ist, die Blindleistung während 4 Zyklen von 5 Zyklen der Wechselspannung injiziert wird.

8. Verfahren nach einem der Ansprüche 1 bis 7, wobei der Schritt e) ein Bestätigen des Inselbildungsfehlers umfasst, wenn der Fehlerbestätigungszähler 3 ist.

9. Verfahren nach einem der Ansprüche 1 bis 8, wobei im Schritt b) die Blindleistung abwechselnd in Plus- und Minus-Richtungen injiziert wird.

10. Verfahren nach Anspruch 1,

wobei im Schritt c), wenn der Fehlerbestätigungszähler 2 ist, die Frequenz zu vier Zeitpunkten im zweiten Abschnitt gemessen wird und die Kreisfrequenz zu ersten und letzten Zeitpunkten der vier Zeitpunkte unter Verwendung einer nachstehenden Gleichung gemessen wird:

$$|\omega_1 - \omega_4| \geq |2\pi\, \Delta f_{inj}| \quad ;$$

$$(f_1 < f_2 < f_3 < f_4) \ \text{oder} \ (f_1 > f_2 > f_3 > f_4) \ ;$$

und

$$|f_1 - f_4| \geq \Delta f_{inj}$$

wobei $\omega_1$ die Kreisfrequenz ist, die zum ersten Zeitpunkt der vier Zeitpunkte gemessen wird, $\omega_4$ die Kreisfrequenz ist, die zum letzten Zeitpunkt unter den vier Zeitpunkten gemessen wird, $f_1$, $f_2$, $f_3$, $f_4$ die sequentiell zu den vier Zeitpunkten gemessenen Frequenzen sind, und $\Delta f_{inj}$ ein Inkrement der Frequenz der Blindleistung ist.


**Revendications**

1. Procédé permettant de déterminer l'îlôtage d'un système dans lequel un réseau (20) et une alimentation électrique distribuée (10) fournissent de l'énergie à une charge (30), le procédé comprenant les étapes consistant à:

a) calculer une quantité d'injection de puissance réactive sur la base d'une instruction de puissance active et d'une instruction de puissance réactive reçues en provenance d'un contrôleur extérieur à l'alimentation électrique distribuée (10), et définir un nombre de confirmations de défaillance à 0;
b) injecter une puissance réactive pendant un cycle prédéfini parmi des cycles prédéterminés d'une tension CA qui est une tension CA de sortie de l'alimentation électrique distribuée (10) en fonction du nombre de confirmations de défaillance;
c) mesurer une fréquence et une fréquence angulaire de la tension CA, la mesure étant effectuée simultanément à l'étape b);
d), une fois l'étape b) terminée, augmenter le nombre de confirmations de défaillance si un critère de détermination basé sur la fréquence et la fréquence angulaire mesurées à l'étape c) est satisfait; et
e), une fois l'étape d) terminée, déterminer une défaillance d'îlotage lorsque le nombre de confirmations de défaillance atteint une valeur prédéfinie,
dans lequel l'étape b), l'étape c), l'étape d) et l'étape e) sont répétées jusqu'à ce que la défaillance d'îlotage soit confirmée à l'étape e),
dans lequel, à l'étape c), la fréquence angulaire est mesurée en mesurant une sortie de PLL incluse dans l'alimentation électrique distribuée (10),
dans lequel, à l'étape b), la puissance réactive est injectée pendant une première section dans laquelle la puissance réactive augmente linéairement, une deuxième section dans laquelle la puissance réactive est maintenue, et une troisième section dans laquelle la puissance réactive diminue linéairement, et
dans lequel, à l'étape c), lorsque le nombre de confirmations de défaillance est égal à 0 ou 1, la fréquence est mesurée à trois moments dans la deuxième section, et la fréquence angulaire est mesurée au premier et au dernier point temporel parmi les trois points temporels, et

dans lequel, à l'étape d), si tous les critères de détermination ci-dessous sont satisfaits, le nombre de confirmations d'échec est augmenté:

$$|\omega_1 - \omega_3| \geq |2\pi\Delta f_{inj}|$$ ;

et

$$(f_1 < f_2 < f_3) \quad \text{ou} \quad (f_1 > f_2 > f_3)$$

dans laquelle $\omega_1$ est la fréquence angulaire mesurée au premier point temporel parmi les trois points temporels, $\omega_a$ est la fréquence angulaire mesurée au dernier point temporel parmi les trois points temporels,, $f_1$, $f_2$ $f_3$ sont les fréquences mesurées séquentiellement aux trois points temporels, et $\Delta f_{inj}$ est un incrément de la fréquence de la puissance réactive.

2. Procédé selon la revendication 1, dans lequel l'étape a) comprend les étapes consistant à:

a-1) mesurer une valeur instantanée de la tension CA au point de connexion entre le réseau (20) et l'alimentation électrique distribuée (10) à l'aide d'un circuit de mesure de tension inclus dans l'alimentation électrique distribuée (10), et calculer une valeur efficace et une fréquence de la tension CA à l'aide de la valeur instantanée;

a-2) calculer une valeur de résistance de la charge, $R_{Load}$ (30), à l'aide de la puissance active fournie par l'alimentation électrique distribuée (10);

a-3) calculer une valeur d'inductance, $L_{Load}$, et une valeur de capacité, $C_{Load}$, de la charge (30) à l'aide d'un coefficient $Q_f$ conformément aux équations suivantes:

$$L_{Load} = \frac{R_{load}}{2\pi f_{arid}Q_f}$$

$$C_{Load} = \frac{Q_f}{2\pi f_{grid}R_{load}}$$

dans laquelle $f_{grid}$ est la fréquence de la tension CA calculée à l'étape a-1); et

a-4) calculer la quantité d'injection de puissance réactive à l'aide de la valeur effective de la tension CA, la valeur d'inductance, la valeur de condensateur et une amplitude de la fréquence de la puissance réactive.

3. Procédé selon la revendication 2, dans lequel à l'étape a-1), la valeur effective et la fréquence de la tension CA sont calculées de manière répétée à intervalles réguliers à l'aide de la valeur instantanée.

4. Procédé selon la revendication 2 ou 3, dans lequel à l'étape a-4), la quantité d'injection de puissance réactive est calculée à l'aide de l'équation ci-dessous:

$$Q_{inj} = V_{rms}^2 * \left(\frac{1}{2\pi f_{inj}L_{load}} - 2\pi f_{inj}C_{load}\right)$$

dans laquelle, $Q_{inj}$ est la quantité d'injection de puissance réactive, $V_{rms}$ est la valeur effective de la tension CA, $f_{inj}$ est l'amplitude de la fréquence de la puissance réactive, $L_{load}$ est la valeur d'inductance de la charge (30) et $C_{load}$ est la valeur de capacité de la charge (30).

5. Procédé selon la revendication 4, dans lequel l'étape a-4) détermine l'amplitude de la fréquence de la puissance réactive selon ce qui suit:

$$f_{inj} = f_{grid} + \triangle f_{inj}$$

$$-Q_{acc} * Q_{rated} < Q_{inj} < +Q_{acc} * Q_{rated}$$

$$f_{grid} = 2\pi \cdot 1/\sqrt{(L_{load} \cdot C_{load})}$$

$$Q_{inj} = V_{rms}^2 * \left(\frac{1}{2\pi f_{inj} L_{load}} - 2\pi f_{inj} C_{load}\right)$$

$f_{grid}$ est une fréquence du réseau (20), $\Delta f_{inj}$ est un incrément de la fréquence de la puissance réactive, $Q_{acc}$ est une précision prédéfinie de la puissance réactive, et $Q_{rated}$ est une puissance réactive nominale de l'alimentation électrique distribuée (10).

6. Procédé selon l'une quelconque des revendications 1 à 5, dans lequel à l'étape b), la puissance réactive est injectée pendant m cycles parmi n cycles de la tension CA, et à mesure que le nombre de confirmations de défaillance augmente, les valeurs m et n sont modifiées de manière à ce que la valeur obtenue en divisant m par n augmente.

7. Procédé selon la revendication 6, dans lequel à l'étape b),

   lorsque le nombre de confirmations de défaillance est égal à 0, la puissance réactive est injectée pendant 3 cycles sur les 8 cycles de la tension CA,
   lorsque le nombre de confirmations de défaillance est égal à 1, la puissance réactive est injectée pendant 3 cycles sur les 5 cycles de la tension CA,
   lorsque le nombre de confirmations de défaillance est égal à 2, la puissance réactive est injectée pendant 4 cycles sur les 5 cycles de la tension CA.

8. Procédé selon l'une quelconque des revendications 1 à 7, dans lequel l'étape e) comprend la confirmation de la défaillance d'îlotage lorsque le nombre de confirmations de défaillance est égal à 3.

9. Procédé selon l'une quelconque des revendications 1 à 8, dans lequel à l'étape b), la puissance réactive est injectée alternativement dans les directions positive et négative.

10. Procédé selon l'une quelconque de la revendication 1,

   dans lequel, à l'étape c), lorsque le nombre de confirmations de défaillance est égal à 2, la fréquence est mesurée à quatre points temporels dans la deuxième section, et la fréquence angulaire est mesurée au premier et au dernier des quatre points temporels, à l'aide de l'équation suivante:

$$|\omega_1 - \omega_4| \geq |2\pi\Delta f_{inj}| \quad ;$$

$$(f_1 < f_2 < f_3 < f_4) \quad \text{ou} \quad (f_1 > f_2 > f_3 > f_4) \quad ;$$

   et

$$|f_1 - f_4| \geq \Delta f_{inj}$$

   dans laquelle $\omega_1$ est la fréquence angulaire mesurée au premier point temporel parmi les quatre points temporels, $\omega_4$ est la fréquence angulaire mesurée au dernier point temporel parmi les quatre points temporels, $f_1$, $f_2$, $f_3$, $f_4$ sont les fréquences mesurées séquentiellement aux quatre points temporels, et $\Delta f_{inj}$ est un incrément de la fréquence de la puissance réactive.

FIG. 1

FIG. 2

FIG. 3

```
                    ( Start )
                        │
    ┌───────────────────────────────────────────┐
    │ Calculate reactive power injection,       │
    │ Set failure confirmation count to 0       │
    └───────────────────────────────────────────┘
                        │
 ┌──────────────────────┼─────────────────────────────────────────────────┐
 │                      │                                                   │
 │            ◇ Failure confimation ◇──N──◇ Failure confimation ◇──N──┐     │
 │            ◇    count == 0        ◇      ◇    count == 1       ◇    │     │
 │                      │Y                        │Y                   │     │
 │   ┌──────────────────────────┐ ┌──────────────────────────┐ ┌──────────────────────────┐
 │   │ Reactive power injection │ │ Reactive power injection │ │ Reactive power injection │
 │   │ for 3 among 8 cycles of  │ │ for 3 among 5 cycles of  │ │ for 4 among 5 cycles of  │
 │   │ AC voltage,              │ │ AC voltage,              │ │ AC voltage,              │
 │   │ Frequency measurement,   │ │ Frequency measurement,   │ │ Frequency measurement,   │
 │   │ Angular frequency        │ │ Angular frequency        │ │ Angular frequency        │
 │   │ measurement              │ │ measurement              │ │ measurement              │
 │   └──────────────────────────┘ └──────────────────────────┘ └──────────────────────────┘
 │                      │                                                   │
 │      N      ◇ Satisfy Determination ◇              ◇ Satisfy Determination ◇──N──┐
 │   ┌─────────◇     Criteria 1?       ◇              ◇     Criteria 2?       ◇      │
 │   │                  │Y                                      │Y                   │
 │   │    ┌──────────────────────────────────────┐             │                    │
 │   │    │ Increase failure confirmation count  │◄────────────┘                    │
 │   │    │ by 1                                 │                                  │
 │   │    └──────────────────────────────────────┘                                  │
 │   │                  │                                                            │
 │   │  N    ◇ Failure confirmation ◇                                               │
 │   └───────◇    count == 3        ◇                                               │
 │                      │Y                                                          │
 │       ┌──────────────────────────────┐                                          │
 │       │ Charger operation terminated │                                          │
 │       └──────────────────────────────┘                                          │
 └─────────────────────────────────────────────────────────────────────────────────┘
```

19

FIG. 4

Start to calculate reactive power injection

Receive $P_{target}$ and $Q_{target}$ from upper controller

Calculate $V_{rms}$ and $f_{ac}$ using $V_{inst}$

Calculate $L_{load}$ and $C_{load}$

Calculate $Q_{inj}$

FIG. 5

**Reactive Power Injection**

**Frequency Calculation (every AC voltage cycle)**

**Angular Frequency (PLL Output)**

**Islanding Confirm Count**

Time point where Islanding occurs

Failure confirmation and Operation stopped

FIG. 6

**EP 4 478 569 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 2020161868 A1
- US 2018348308 A1